# EUROPEAN PATENT SPECIFICATION

(11) **EP 0 252 679 B1**
(45) Date of publication and mention of the grant of the patent: **05.05.1993**
(21) Application number: 87305826.7
(22) Date of filing: 01.07.1987
(51) Int. Cl.: H01L 29/40, H01L 21/28

(54) **Semiconductor device having two electrodes with an insulating film between them**
Halbleiteranordnung mit zwei durch eine Isolationsschicht getrennten Elektroden
Dispositif semi-conducteur ayant deux électrodes séparées par un film isolant

(30) Priority: 10.07.1986 JP 162472/86
(43) Date of publication of application: 13.01.1988
(73) Proprietor: SEIKO INSTRUMENTS INC., Tokyo 136 (JP)
(72) Inventor: Hosaka, Takashi, Koto-ku Tokyo (JP)
(74) Representative: Miller, Joseph

(56) References cited:
- EP-A- 0 002 997
- EP-A- 0 118 878
- US-A- 4 577 390
- IEEE INTERNATIONAL SOLID-STATE CIRCUITS CONFERENCE, vol. 24, February 1981, pages 152-153, IEEE, New York, US; H.H.CHAO et al.: "A 34mum2 DRAM cell fabricated with a 1mum single-level polycide FET technology"
- SOLID STATE TECHNOLOGY, vol. 20, no. 4, April 1977, pages 63-70, New York, US; R.S.ROSLER: "Low pressure CVD production processes for poly, nitride, and oxide"

## Description

This invention concerns a semiconductor device such, for example, as a non-volatile memory or a capacitive component.

A semiconductor device is known comprising first and second electrodes with an insulation film therebetween, at least the first electrode being formed of material comprising polycrystalline silicon. For example, an insulation film made by the chemical vapour deposition (CVD) process, a polyimide film and a thermally oxidized film of polycrystalline silicon have been used as the said insulation film, while the second electrode has incorporated wiring and has been made, for example, of a conductive material such as aluminium or polycrystalline silicon.

However, if the thickness of the insulation film is less than 1,000 Å(10Å = 1 nm), a thermally oxidized film of polycrystalline silicon has to be used as the insulation film because it has a good insulating performance and thickness controllability.

In order to produce integrated circuits (IC) which are miniaturized and can be operated at high speeds, polycrystalline silicon as a material for an electrode and wiring has, in certain fields, been gradually replaced by so-called polycide material, ie. material formed from polycrystalline silicon and a metal silicide. For example, the polycide material may comprise a two layered structure of polycrystalline silicon and a metal silicide.

Document IEEE Int. Solid-State Ccts. Conference Vol. 24, Feb 1981, Pages 152-153 discloses a semiconductor device having a polycide first electrode and a second electrode with a silicon dioxide insulation layer therebetween. The insulation layer is formed by chemical vapour deposition and the material of the first electrode also comprises polycrystalline silicon and at least one metal silicide.

However, a thermally oxidized film of polycide does not have uniform film thickness and does not have a good insulating performance. Accordingly, since the insulating performance of a thin insulating film of less than 1,000 Å thickness formed by thermally oxidizing the periphery of polycide material used as the wiring and the electrode is also poor, it has been impossible to use the polycide as the material for the electrode and the wiring of a semiconductor device.

Thus if polycide material were used as the electrode and the wiring of a lower layer of a semiconductor device and the electrode and the wiring of an upper layer thereof were formed thereover with a thin insulation film therebetween, a thermally oxidized film formed by thermally oxidizing the periphery of the polycide material would not be satisfactory because it would not have uniform film thickness or adequate insulating performance. Accordingly, since the insulating performance of a thin insulating film of less than 1,000 Å formed by thermally oxidizing the periphery of the polycide is also poor, it has been impossible to use the polycide as the material for the electrode and the wiring of a semiconductor device. Therefore, it has been impossible to obtain a satisfactory semiconductor device which could be operated at high speed because of the reduced resistance of the electrode and the wiring in such a device.

Accordingly, therefore, to the present invention, there is provided a non-volatile device comprising floating gate and control gate electrodes with an insulation film therebetween which has been formed by a chemical vapour deposition process characterised in that the insulation film is a silicon oxide film formed by a chemical gas phase reaction using a dichlorosilane (SiH₂Cℓ₂) gas and a nitrous oxide (N₂O) gas and having a thickness which does not exceed 1,000 Å, the material of the floating gate electrode comprising a polycide.

Preferably, the first electrode has a plurality of layers. Thus the first electrode may comprise a metal silicide membrane laminated to a polycrystalline silicon membrane.

The chemical gas phase reaction may have been carried out by arranging that the relative N₂O/SiH₂Cℓ₂ flow rate is at least 5.

The said reaction has been preferably effected under a reduced pressure in the range of 0.1 mbar and 2 mbar and a temperature in the range of 700°C to 950°C.

Preferably, the said first and second electrodes incorporate wiring.

The first electrode may be mounted directly or indirectly on a substrate.

The semiconductor device may be a non-volatile memory having a floating gate.

In its preferred form, the semiconductor device of the present invention employs, as an insulation film on a polycide electrode and wiring, a silicon oxide (SiO₂) film formed by using a chemical vapour deposition process (CVD) process, the silicon oxide film being formed by reacting a dichlorosilane (SiH₂Cℓ₂) gas and a nitrous oxide (N₂O) gas in a chemical gas phase reaction under a high temperature atmosphere (hereinafter referred to as high temperature CVD silicon oxide film). The process may be carried out at a reduced pressure of from 0.1 mbar to 2 mbar and at a temperature of 700°C to 950°C.

Such a high temperature CVD SiO₂ film is advantageous because it can be given uniform film thickness and because it has an extremely satisfactory insulating performance. Accordingly, it can be used also as a thin insulating film with a thickness of less than 1000 Å and it can also be formed over a polycide electrode and wiring of the semiconductor device.

The invention is illustrated merely by way of example, in the accompanying drawings, in which:-
Figure 1 is a cross sectional view illustrating a first embodiment of a semiconductor device according to the present invention,
Figure 2 is a cross sectional view illustrating a second embodiment constituting a capacitive component, and
Figure 3 is a cross sectional view illustrating a third embodiment constituting a non-volatile memory.

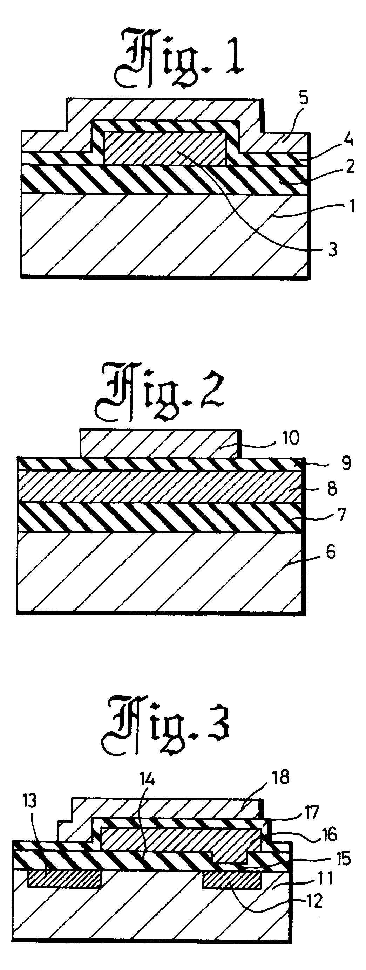

In Figure 1 there is shown a semiconductor device according to the present invention in which, after an insulation layer 2 has been formed on a substrate 1, a polycide electrode and wiring 3 is formed on the insulation layer 2. The polycide electrode and wiring 3, as indicated above, comprises polycrystalline silicon and a metal silicide. Then a CVD silicon oxide insulation film 4 is layered over the polycide electrode and wiring 3 by using a CVD process. An electrode and wiring 5 is then formed over the CVD silicon oxide insulation film 4 to obtain the semiconductor device shown in Figure 1.

The substrate 1 shown in Figure 1 may be a semiconductor such as of silicon, germanium, gallium arsenide and indium phosphide; an insulator such as glass or aluminium; or a metal such as stainless steel or iron.

The insulation layer 2 may be constituted by a silicon oxide film, a silicon nitride film, alumina, etc, although of course, the insulation layer 2 may be dispensed with.

The polycide electrode and wiring 3 may be formed generally as described below. At first, a polycrystalline silicon film is formed by means of a chemical vapor deposition process (CVD process) or by means of a physical vapor deposition process (PVD process), etc. In this case, the polycrystalline silicon film may be doped with phosphorus,arsenic or boron. The doping may be conducted after the formation of the polycrystalline silicon film. Generally, doping is conducted by using a diffusion process. Of course, doping of the polycrystalline silicon film may be dispensed with.

Heat treatment of the polycrystalline silicon film may be carried out after the formation of the polycrystalline silicon film, but heat treatment may, of course be dispensed with.

Then, a silicide film is laminated over the polycrystalline silicon film by way of a CVD process or a PVD process. The silicide film usable herein can include molybdenum silicide, tungsten silicide, platinum silicide, titanium silicide, tantalum silicide, zirconium silicide and palladium silicide. Then, heat treatment may be applied to stabilize the composition which has been formed so far.

The said polycide electrode and wiring 3 may be constituted by a dual layered film prepared by laminating a silicide membrane on a polycrystalline silicon membrane.

Another method of preparing the polycide electrode and hiring 3 is to prepare a metal film over a polycrystalline silicon film, followed by heat treatment. The metal film is formed by a CVD or a PVD process. The metal film usable herein can include, for example, molybdenum, tungsten, platinum, titanium, tantalum, zirconium and palladium.

Reference is now made to the CVD silicon oxide film 4 formed over the polycide electrode and wiring 3. The silicon oxide film 4 may be laminated to the polycide electrode and wiring 3 by using a CVD process since this shows a satisfactory insulating performance even on the polycide film. In particular, a silicon oxide film 4 prepared by a chemical deposition process by using a dichlorosilane (SiH₂Cℓ₂) gas and a nitrous oxide (N₂O) gas has an extremely good insulating performance. The density of a membrane of the silicon oxide film grown from a dichlorosilane (SiH₂Cℓ₂) gas and a nitrous oxide (N₂O) gas suffers from an effect arising from the pressure and temperature used upon formation. The silicon oxide film 4, however, is preferably formed under a pressure substantially within the range 0.1 mbar to 2.0 mbar and at a temperature within the range 700°C to 950°C. The silicon oxide film 4 prepared under the above-mentioned conditions is satisfactory so far as film thickness controllability is concerned and has adequate insulating performance and a satisfactory density. Further, if the proportion of the dichlorosilane (SiH₂Cℓ₂) gas becomes too high, the silicon oxide film 4 may contain too much silicon with the result that its insulating performance is reduced and, accordingly, a desirable insulating performance can be obtained by setting the ratio of the flow rate between N₂O/SiH₂Cℓ₂ at a value of at least 5.

Since a silicon oxide film 4 formed under a pressure from 0.1 mbar to 2.0 mbar and at a temperature from 700°C to 950°C has a good film thickness controllability, a thin film of less than 1000 Å can be laminated uniformly over the polycide electrode and wiring 3.

An explanation will now be provided concerning the formation of a capacitive component for use with a semiconductor device. A device having a capacitance for providing electric charges has often been used in dynamic RAMs or analog and digital circuits. In the case of forming a capacitive component using a silicon oxide film as an insulation film between electrodes, it is necessary to form a thin insulation film in order to obtain a large capacity with a small surface area and it is also required that there is little leakage of the accumulated electric charges. If a capacitive component is made with an insulation film disposed over a polycide film, the insulation film may be formed by a CVD process using a SiH₂Cℓ₂ gas and an N₂O gas in order to obtain desired capacitance characteristics. Although the structure shown in Figure 1 also constitutes a capacitive component, the formation of a capacitive component will be described in greater detail with reference to Figure 2.

The reference numerals 6, 7, 8, 9 and 10 in Figure 2 respectively correspond to the reference numerals 1, 2, 3, 4, 5 in Figure 1. An extremely thin CVD silicon oxide film 9 having a thickness of not more than 1000 Å is laminated over a polycide film 8 i.e. a film comprising polycrystalline silicon and at least one metal silicide, and, an electrode and wiring 10 is formed over the silicon oxide film 9. Then, a capacitive component is formed which is constituted by the polycide film 8, the silicon oxide film 9 formed through the reaction between SiH₂Cℓ₂ gas and N₂O gas, and the electrode and wiring 10. It is possible to form the silicon oxide film 9 into an extremely thin film of not more than 100 Å thickness if required. When a lateral type vacuum CVD device is used in conditions of growth (with a flow of SiH₂Cℓ₂ gas at 25 sccm and a flow of N₂O gas at 250 sccm, under a pressure of 0.4 mbar and a temperature of 850°C), since the growth rate is 6.2 and the uniformity is not more an ±5%, a silicon oxide film of less than 100 Å thickness can be formed with good controllability. Since the insulating performance of the silicon oxide film is extremely satisfactory, a capacitive component with less electric discharge can be formed within a small surface area.

The present invention is applicable also to a non-volatile memory having a floating gate as will be clear from the description of Figure 3.

In Figure 3, a floating gate electrode 16 is formed from a polycide, i.e. a material comprising polycrystalline silicon and at least one metal silicide. The floating gate electrode 16 is formed on a silicon oxide insulation film 14 which is provided on a silicon substrate 11. A thin CVD silicon oxide film 17 of 100 - 500 Å thickness is laminated over the floating gate electrode 16 and, further, a control gate electrode 18 is formed on the silicon oxide film 17. Electrons are injected from a dense N type impurity region 12 in the silicon substrate 11 by way of a thin silicon oxide film 15 to the floating gate electrode 16, by which the voltage of the floating gate can be changed, a drain region 13 also being provided in the silicon substrate 11.

As the thickness of a thermally oxidized film of polycide is reduced, the voltage which the insulation will withstand is worsened. However,when the CVD silicon oxide film 17 of Figure 3 is used, since an extremely thin insulation film can be formed on the floating gate electrode (polycide) 16, it is easily possible to vary the voltage on the floating gate electrode 16 by using the control gate electrode 18 as an external electrode. Further, since a thin silicon oxide film formed by the CVD process by using a SiH₂Cℓ₂ gas and a N₂O gas (CVD silicon oxide film) has an extremely good insulation property, any electric current leaking externally of the film 17 from the floating gate electrode 16 through the CVD silicon oxide film 17 is extremely low. Accordingly, electrons injected into the floating gate electrode 16 can be stored therein over an extremely long period of time. Therefore, the device constitutes a memory whose characteristics are comparable with those of conventional memories using polysilicon as the floating gate, both in respect of repeated rewriting and of charge retention time. Further, since wiring can be made with low resistance by using the polycide, reading and rewriting can be conducted at a higher speed than usual.

The polycide electrode and wiring can be formed by laminating two or more layers. That is, after forming the polycide at the first layer, a thin CVD silicon oxide film is laminated thereto. Then, after forming the polycide at the second layer, a thin CVD silicon oxide film is again laminated thereto. By repeating the above-described procedures, it is possible to laminate the polycide electrode and wiring to any desired number of layers. A three-layered polysilicon electrode and wiring has been used for non-volatile memories in recent years and it is possible to obtain a non-volatile memory of a three-layered polycide electrode and wiring by using the present invention.

Although a CVD silicon oxide film is laminated directly over the polycide electrode and wiring in the prefered embodiments of the present invention shown in the drawings, identical properties can also be obtained when a thin CVD silicon oxide film is laminated after oxidization of the polycide.

As has been described above, since a thin silicon oxide film formed by using a CVD process can be formed as an insulation film over a polycide electrode and wiring, the polycide electrode and wiring can be used in a device employing a thin insulation film, and a higher operational speed of the device than usual can be attained.

## Claims

1. A non-volatile memory device comprising floating gate and control gate electrodes (3,5) with an insulation film (4) therebetween which has been formed by a chemical vapour deposition process characterised in that the insulation film (4) is a silicon oxide film formed by a chemical gas phase reaction using a dichlorosilane (SiH₂Cℓ₂) gas and a nitrous oxide (N₂O) gas and having a thickness which does not exceed 100 nm the material of the floating gate electrode (3) comprising a polycide.

2. A non-volatile memory device as claimed in claim 1 characterised in that the floating gate electrode (3) has a plurality of layers.

3. A non-volatile memory device as claimed in claim 2 characterised in that the floating gate electrode (3) comprises a metal silicide membrane laminated to a polycrystalline silicon membrane.

4. A non-volatile memory device as claimed in any preceding claim characterised in that the chemical gas phase reaction has been carried out by arranging that the relative N₂O/SiH₂Cℓ₂ flow rate is at least 5.

5. A non-volatile memory device as claimed in any preceding claim characterised in that the said reaction has been effected under a reduced pressure in the range of 0.1 mbar to 2 mbar and a temperature in the range of 700°C to 950°C.

6. A non-volatile memory device as claimed in any preceding claim characterised in that the said floating gate and control gate electrodes (3,5) incorporate wiring.

7. A non-volatile memory device as claimed in any preceding claim characterised in that the floating gate electrode (3) is mounted directly or indirectly on a substrate (1).

8. A method of making a non-volatile memory device which comprises floating gate and control gate electrodes (3,5) with an insulation film (4) therebetween which has been formed by a chemical vapour deposition process characterised in that the insulation film (4) is a silicon oxide film formed by a chemical gas phase reaction using a dichlorosilane (SiH₂Cℓ₂) gas and a nitrous oxide (N₂O) gas and having a thickness which does not exceed 100 nm the material of the floating gate electrode (3) comprising a polycide.

## Patentansprüche

1. Nichtflüchtige Speicheranordnung mit einer Floating-Gate- und einer Steurgateelektrode (3, 5,) sowie einer zwischen diesen befindlichen durch chemische Abscheidung aus der Gasphase gebildeten Isolationsschicht (4), **dadurch gekennzeichnet**, daß die Isolationsschicht (4) eine durch chemische Gasphasenreaktion unter Verwendung von Dichlorsilan (SiH₂Cl₂)-Gas und Stickstoffoxid (N₂O)-Gas gebildete Siliziumoxidschicht mit einer 100 nm nicht übersteigenden Dicke ist und daß die Floating-Gate-Elektrode (3) ein Polycid umfaßt.

2. Nichtflüchtige Speicheranordnung nach Anspruch 1, **dadurch gekennzeichnet**, daß die Floating-Gate-Elektrode (3) eine Vielzahl von Schichten besitzt.

3. Nichtflüchtige Speicheranordnung nach Anspruch 2, **dadurch gekennzeichnet**, daß die Floating-Gate-Elektrode (3) eine auf eine Membran aus polykristallinem Silizium auflaminierte Membran aus einem Metallsilicid umfaßt.

4. Nichtflüchtige Speicheranordnung nach den vorhergehenden Ansprüchen, **dadurch gekennzeichnet**, daß die chemische Gasphasenreaktion so durchgeführt wird, daß die relative N₂O/SiH₂Cl₂-Strömungsgeschwindigkeit auf wenigstens 5 eingestellt ist.

5. Nichtflüchtige Speicheranordnung nach den vorhergehenden Ansprüchen, **dadurch gekennzeichnet**, daß die Reaktion bei einem reduzierten Druck im Bereich von 0,1 mbar bis 2 mbar und einer Temperatur im Bereich von 700° C bis 950° C durchgeführt wird.

6. Nichtflüchtige Speicheranordnung nach den vorhergehenden Ansprüchen, **dadurch gekennzeichnet**, daß die Floating-Gate- und Steuergateelektrode (3, 5) eine Verdrahtung beinhalten.

7. Nichtflüchtige Speicheranordnung nach den vorhergehenden Ansprüchen, **dadurch gekennzeichnet**, daß die Floating-Gate-Elektrode (3) direkt oder indirekt auf einem Substrat (1) vorgesehen ist.

8. Verfahren zur Herstellung einer nichtflüchtigen Speicheranordnung mit einer Floating-Gate- und einer Steuergateelektrode (3, 5) sowie einer zwichen diesen befindlichen durch chemische Abscheidung aus der Gasphase gebildeten Isolationsschicht (4), **dadurch gekennzeichnet**, daß die Isolationsschicht (4) eine durch chemische Gasphasenreaktion unter Verwendung von Dichlorsilan (SiH₂Cl₂)-Gas und Stickstoffoxid (N₂O)-Gas gebildete Siliziumoxidschicht mit einer 100 nm nicht übersteigenden Dicke ist und daß die Floating-Gate-Elektrode (3) ein Polycid umfaßt.

## Revendications

1. Un dispositif de mémoire non volatile comprenant des électrodes de grille flottante et de grille de commande (3, 5) séparées par une couche d'isolation (4) qui a été formée par un procédé de dépôt chimique en phase vapeur, caractérisé en ce que la couche d'isolation (4) est une couche d'oxyde de silicium formée par une réaction chimique en phase gazeuse utilisant un gaz qui consiste en dichlorosilane (SiH₂Cl₂) et un gaz qui consiste en oxyde nitreux (N₂O) et ayant une épaisseur qui ne dépasse pas 100 nm, le matériau de l'électrode de grille flottante (3) consistant en une combinaison de silicium polycristallin et d'un siliciure de métal.

2. Un dispositif de mémoire non volatile selon la revendication 1, caractérisé en ce que l'électrode de grille flottante (3) comprend plusieurs couches.

3. Un dispositif de mémoire non volatile selon la revendication 2, caractérisé en ce que l'électrode de grille flottante (3) comprend une pellicule de siliciure de métal déposée sur une pellicule de silicium polycristallin.

4. Un dispositif de mémoire non volatile selon l'une quelconque des revendications précédentes, caractérisé en ce que la réaction chimique en phase gazeuse a été accomplie en fixant le rapport de débit N₂O/SiH₂Cl₂ à une valeur au moins égale à 5.

5. Un dispositif de mémoire non volatile selon l'une quelconque des revendications précédentes, caractérisé en ce que la réaction précitée a été effectuée sous une pression réduite dans la plage de 0,1 hPa à 2 hPa, et à une température dans la plage de 700°C à 950°C.

6. Un dispositif de mémoire non volatile selon l'une quelconque des revendications précédentes, caractérisé en ce que les électrodes de grille flottante et de grille de commande ( 3, 5 ) comprennent des interconnexions.

7. Un dispositif de mémoire non volatile selon l'une quelconque des revendications précédentes, caractérisé en ce que l'électrode de grille flottante (3) est montée directement ou indirectement sur un substrat (1).

8. Un procédé de fabrication d'un dispositif de mémoire non volatile qui comprend des électrodes de grille flottante et de grille de commande (3, 5) séparées par une couche d'isolation (4) qui a été formée par un procédé de dépôt chimique en phase vapeur, caractérisé en ce que la couche d'isolation (4) est une couche d'oxyde de silicium formée par une réaction chimique en phase gazeuse utilisant un gaz qui consiste en dichlorosilane (SiH₂Cl₂) et un gaz qui consiste en oxyde nitreux (N₂O), et ayant une épaisseur qui ne dépasse pas 100 nm, le matériau de l'électrode de grille flottante (3) consistant en une combinaison de silicium polycristallin et de siliciure de métal.
